# EUROPÄISCHE PATENTSCHRIFT

(11) **EP 3 551 787 B1**
(45) Veröffentlichungstag und Bekanntmachung des Hinweises auf die Patenterteilung: **02.06.2021**
(21) Anmeldenummer: 17816392.9
(22) Anmeldetag: 07.12.2017
(51) Int. Cl.: C25F 3/18, C25F 3/20, C25F 3/22, C25F 3/26, C25F 7/00

(54) **ELEKTROPOLIERVERFAHREN UND ANLAGE HIERZU**
ELECTROPOLISHING METHOD AND SYSTEM THEREFOR
PROCÉDÉ D'ÉLECTROPOLISSAGE ET INSTALLATION ASSOCIÉE

(30) Priorität: 09.12.2016 AT 511192016
(43) Veröffentlichungstag der Anmeldung: 16.10.2019
(73) Patentinhaber: RENA Technologies Austria GmbH, 2552 Hirtenberg (AT)
(72) Erfinder: HANSAL, Wolfgang, 2753 Mark Piesting (AT); HANSAL, Selma, 2753 Mark Piesting (AT); MANN, Rudolf, 1140 Wien (AT); SANDULACHE, Gabriela, 2560 Berndorf (AT)
(74) Vertreter: Schwarz & Partner Patentanwälte OG
(86) Internationale Anmeldenummer: PCT/AT2017/060325
(87) Internationale Veröffentlichungsnummer: WO 2018/102844

(56) Entgegenhaltungen:
- DE-T2-602005 005 383
- US-A- 6 143 158
- US-A1- 2008 067 077
- US-A1- 2011 303 553
- US-A1- 2016 093 898

## Beschreibung

Die Erfindung betrifft ein Elektropolierverfahren, insbesondere für im 3D-Druck hergestellte Bauteile aus Metall, wobei zumindest ein zu bearbeitender Bauteil als erste Elektrode fungiert und zumindest zweite Elektrode als Gegenelektrode vorgesehen ist, und zumindest ein teilweiser Abtrag eines Bereichs der Bauteiloberfläche in einem Elektrolytbad durch Anlegen von Strom an dem Bauteil erfolgt.

Das Glätten von metallischen Oberflächen erfolgt in der industriellen Produktion mit verschiedenen Methoden. Die endgültige Wahl der Methode hängt von der Ausgangsrauigkeit ab, unterschieden wird hier grundsätzlich zwischen mechanischen, chemischen und elektrochemischen Verfahren.

Bei dem elektrochemischen Verfahren, dem Elektropolieren, erfolgt der Abtrag durch die elektrolytische Auflösung der Metallionen von der Werkstückoberfläche, mit dem Zweck, Mikrorauigkeiten zu eliminieren. Das Elektropolieren dient auch dem Entgraten, Glänzen und Passivieren. Ein wesentlicher Vorteil des Elektropolierens besteht darin, dass das Werkstück praktisch keinen mechanischen Belastung ausgesetzt ist. Damit ist diese Methode besonders für kleine und empfindliche Teile in nahezu jeder Größe und jeder Form geeignet.

Beim Elektropolieren wird das Werkstück in einen Elektrolyten eingetaucht und durch Anlegen von Strom wird das Material am Werkstück (Anode) abgetragen. Hierbei gehen die Metallionen im Elektrolyten in Lösung, als Gegenelektrode (Kathode) dient zumeist ein inertes Blech.

Beim Elektropolieren ist grundsätzlich zu beachten, dass das Basismaterial nicht angegriffen (geätzt oder gebeizt) wird und kein signifikanter Materialangriff/-abtrag erfolgt. Beim klassischen Elektropolieren wird das anodische Potenzial so gewählt, dass es im transpassiven Bereich der Strom-Spannungskurve liegt. In diesem Bereich bildet sich an der Oberfläche des Teiles ein sogenannter "Polierfilm" aus, der für einen homogenen Abtrag des Metalls verantwortlich ist und die Oberfläche einebnet.

Die Teile werden beim Elektropolieren weder mechanischen, noch hohen thermischen Belastungen ausgesetzt, und stoßen nicht aneinander. Die Ergebnisse lassen sich mit hoher Genauigkeit reproduzieren.

Im Stand der Technik sind hierzu zahlreiche Verfahren insbesondere für gefräste oder gestanzte Teile bekannt. Diese werden vor allem in der Medizintechnik und im Lebensmittelbereich eingesetzt. Dabei werden meist Standardelektrolyte verwendet, die auf das jeweilige Material, meist Edelstahl, seltener Aluminium oder andere Jeder dieser Verfahrensschritte kann unter Umständen mehrere hintereinandergeschaltete Bäder erfordern, um das gewünschte Resultat zu erzielen.

Im Stand der Technik sind hierzu zahlreiche Verfahren insbesondere für gefräste oder gestanzte Teile bekannt. Diese werden vor allem in der Medizintechnik und im Lebensmittelbereich eingesetzt. Dabei werden meist Standardelektrolyte verwendet, die auf das jeweilige Material, meist Edelstahl, seltener Aluminium oder andere Leichtmetalle, abgestimmt sind. Hier wird der für das Glätten erforderliche Abtrag lediglich über die Elektrolytzusammensetzung gesteuert oder potenzialkontrolliert unter Verwendung von Gleichstrom.

Es sind des Weiteren Pulsverfahren zum Elektropolieren bekannt geworden, bei welchen über Rechteckspulse in sich wiederholenden Pulssequenzen der gewünschte Abtrag eingestellt wird.

So beschreibt die WO 2014/018171 A1 ein Verfahren zum elektrochemischen Polieren von supraleitenden Hochfrequenzhohlräumen mittels Pulsverfahren. Ein ähnliches Verfahren für das Entgraten und Elektropolieren von Stents ist in der WO 2005/066395 A2 offenbart. Weitere Verfahren zum elektrochemischen Polieren mittels Pulsverfahren können auch der WO 2003/088316 A2, der WO 2003/046262 A oder der US 6,558 231 B1 entnommen werden.

Die bekannt gewordenen Verfahren haben den Nachteil, dass sie für Werkstücke mit einer heterogenen Ausbildung der Oberflächenrauigkeiten, also Bereiche mit hoher Rauigkeit und Bereiche mit geringer Rauigkeit auf einem einzelnen Werkstück nur wenig geeignet sind, da jedes dieser Einzelverfahren für einen bestimmten Rauheitsbereich optimal geeignet ist.

Es ist daher die Aufgabe der Erfindung, ein Verfahren bereitzustellen, das die Bearbeitung von Metallteilen mit unterschiedlich hoher Oberflächenrauigkeit zu behandeln und eine definierte Oberflächenrauigkeit einzustellen erlaubt.

Diese Aufgabe wird erfindungsgemäß dadurch gelöst, dass in einem ersten Schritt eine Reinigung erfolgt, wobei in einem zweiten Schritt zumindest ein zu bearbeitender Bauteil als erste Elektrode fungiert und zumindest eine zweite Elektrode als Gegenelektrode vorgesehen ist, und zumindest ein teilweiser Abtrag eines Bereichs der Bauteiloberfläche in einem Elektrolytbad durch Anlegen von Strom an dem Bauteil erfolgt, wobei der Strom in Form von sich wiederholenden Pulssequenzen angelegt wird, wobei zumindest ein anodischer Puls vorgesehen ist, dessen Stromstärke im zeitlichen Verlauf einen stetigen Anstieg bis zu einem vorgebbaren Wert aufweist, wobei bevorzugterweise der Anstieg linear, nicht-linear oder exponentiell ist, wobei anschließend an den Anstieg der anodische Puls Mikropulse aufweist. Somit weist dieser anodische Puls keine wie im Stand der Technik übliche Rechtecksform auf, sondern seine Stromstärke erhöht sich im Zug der Pulsdauer, sodass kein sprunghafter, sondern ein stetiger Anstieg der Stromstärke in Form einer nichtlinearen Flanke oder linearen Rampe über die Pulsdauer erhalten wird.

Die Pulsform, insbesondere die Anstiegs- und gegebenenfalls die Abfallgeschwindigkeit des Stroms sind für den zeitlichen Verlauf der Entstehung und des Abbaus des Polierfilms verantwortlich. Durch gezielte Steuerung des zeitlichen Verlaufs der Pulsflanke kann dieser wesentliche Teil des Polierprozesses optimal durchgeführt werden. Die Kontrolle über den zeitlichen Aufbaus des Polierfilms erlaubt es, die Bereiche Ätzung - Passivierung - Polieren während des Elektropolierens geplant und reproduzierbar zu durchlaufen und damit den Materialabtrag gezielt zu steuern. Bei Metallteilen mit hoher Rauheit kann so durch eine langsam ansteigende Rampe beziehungsweise einen Stufenpuls die Ätzphase verlängert werden und so sowohl die Prozesszeit verkürzt als auch das Ergebnis verbessert werden.

Gemäß der Erfindung weist der Puls anschließend an den Anstieg Mikropulse auf. Dabei werden auf den Puls, dem sogenannten Basispuls, höherfrequente Mikropulse "aufgesetzt". Diese Mikropulse haben den Effekt, dass der Polierprozess beschleunigt wird, weil diese Mikropulse an Spitzen und Kanten aufgrund der Feldlinienkonzentration an diesen Stellen überproportional stark wirken. Des Weiteren wird dadurch die örtliche Stromverteilung über das Werkstück als Funktion der Frequenz der Mikropulse beeinflusst, was wiederum wesentlich für die Glättungswirkung des erfindungsgemäßen Verfahrens ist.

Da die elektrolytische Doppelschichtkapazität auf einer rauen und chemisch inhomogenen Oberfläche, wie sie beispielsweise bei einem 3D-gedruckten Teil üblicherweise vorliegt, lokal unterschiedliche Werte aufweist, ist die Verteilung des Stroms bei höheren Frequenzen anders als bei niedrigen. Der Grund liegt darin, dass der effektive Widerstand einer Kapazität mit steigender Frequenz des angelegten Stroms sinkt, sodass die höherfrequenten Anteile des Strompulses bevorzugt über Stellen mit hoher Kapazität fließen, während der niederfrequente Anteil durch die Bereiche mit niedrigem Polarisationswiderstand fließt. Somit kann die lokale Stromverteilung am Werkstück durch die Pulsform wesentlich beeinflusst werden.

Hierbei ist je nach Anwendung vorgesehen, dass die Pulse eine mittlere Stromdichte von 0,5 A/dm² bis 30 A/dm² und die Pulse und/oder die Pulspausen eine Pulslänge von 0,0005 s bis 5 s aufweisen.

Des Weiteren kann der Elektrolyt zusätzliche Additive, insbesondere Netzmittel, Inhibitoren und/oder Komplexierungsmittel enthalten. Der bei dem erfindungsgemäßen Verfahren üblicherweise eingesetzte Elektrolyt weist eine Temperatur von 5°C bis 90°C und einen pH-Wert von 1 bis 10 auf. Ebenso kann vorgesehen sein, dass der Elektrolyt periodisch oder kontinuierlich bewegt wird. In dem erfindungsgemäßen Verfahren ist insbesondere vorgesehen, dass als Gegenelektroden inerte Kathoden, insbesondere Titankathoden, Bleikathoden, Stahlkathoden oder Edelstahlkathoden eingesetzt werden.

In dem erfindungsgemäße Verfahren ist bevorzugterweise ein Elektrolyt vorgesehen, der aus der Gruppe ausgewählt ist, die einen Elektrolyten auf Basis von Mineralsäuren oder organische Säuren oder eine Mischung von diesen enthält.

Alternativ kann der Elektrolyt auf Basis von Alkalien wie Natronlauge, Kalilauge oder Ammoniak beziehungsweise auf basischen organischen Verbindungen wie Aminen aufgebaut sein.

Nach Beendigung des Elektropolierens erfolgen bevorzugterweise im Anschluss an daran eine Nachbehandlung und/oder ein Beschichtungsschritt. Die Nachbehandlung umfasst üblicherweise das Entfernen von Elektrolytresten und Reaktionsprodukten sowie gegebenenfalls ein Trocknen des bearbeiteten Bauteils.

Durch die Einstellung der gewünschten Oberflächenrauigkeit mittels des erfindungsgemäßen Elektropolierens ist der bearbeitete Bauteil insbesondere für einen nachfolgenden Beschichtungsschritt vorbereitet. Dieser Beschichtungsschritt kann insbesondere Verfahren enthalten, die eine galvanische Beschichtung, eine PVD- oder CVD-Beschichtung, eine Polymerbeschichtung oder eine plasmaelektrolytische Oxidation umfassen.

Das erfindungsgemäße Verfahren hat sich insbesondere in der Verwendung für Bauteile aus Metall hergestellt im 3D-Druck bewährt.

Hierbei erfolgt in einem ersten Schritt eine Reinigung, in einem zweiten Schritt das elektrochemische Polieren und in einem dritten Schritt eine Nachbehandlung des Bauteils.

Die Reinigung umfasst neben der Entfernung von Verschmutzungen, insbesondere Öle, Fette und Oxide, zusätzlich ein mechanisches Vorpolieren bei höheren Rauigkeiten und inhomogenen Topographien und/oder ein Beizen des Bauteils, um einen homogeneren Abtrag zu erzielen.

In einer besonders bevorzugten Ausführung der Erfindung ist vor dem Reinigen des zu bearbeitenden Bauteils zunächst eine Erfassung und Digitalisierung vorgesehen. Anschließend wird der Bauteil mittels Nassstrahlen, vorzugsweise mithilfe eines Jetsystems mit starren oder beweglichen Düsen behandelt, um allfällige Stützstrukturen zu beseitigen. Anschließend erfolgt ein Schleifschritt, insbesondere mittels Gleitschleifen beziehungsweise Schleppfinish. Im Anschluss daran erfolgt das elektrochemische Polieren des vorbereiteten Bauteils.

Nach Abschluss des Elektropolierens ist in manchen Anwendungsbereichen ein zusätzliches Plasmapolieren erforderlich, an das weitere Nachbearbeitungsschritte und gegebenenfalls Beschichtungen anschließen können.

Die oben beschriebenen Schritte zur Bearbeitung insbesondere von 3D-gedruckten Bauteilen können hierbei teilweise auch gleichzeitig, also in einem Verfahrensschritt erfolgen.

Nach dem Erfassen der Geometrie und Oberflächenbeschaffenheit des zu bearbeitenden Bauteils in einer ersten Station werden die Stützstrukturen, sofern vorhanden, in einer zweiten Station durch Nassstrahlen unter Potential entfernt und/oder die Makrorauigkeit der Oberfläche durch Gleitschleifen vermindert, um eine geeignete Oberfläche für den weiteren Schritt Elektropolieren zu erzielen.

Vor dem Elektropolieren werden die Teile in einer Beize gereinigt und anschließend mit Wasser gespült. Die vorgereinigten Teile wurden dann in die Elektropolierlösung getaucht und anodisch geschaltet. Die Arbeitsparameter beim Elektropolieren (Elektropolierlösung, Temperatur, Stromsignal) sind hierbei auf das jeweilige Substratmaterial abgestimmt.

Die resultierenden Oberflächen erfüllen die Anforderung hinsichtlich der Oberflächenrauigkeit für die gegebene Anwendung, eine weitere Bearbeitung ist dafür nicht erforderlich. Je nach Einsatz kann jedoch eine weitere Funktionalisierung der Oberfläche in Form einer Beschichtung oder zusätzlichen Oberflächenbehandlung erfolgen.

Das erfindungsgemäße Verfahren ist insbesondere für Bauteile gefertigt aus Stahl, Nickelbasislegierungen, Aluminiumlegierungen, Magnesiumlegierungen oder Titanlegierungen geeignet.

Im Folgenden wird anhand von nicht-einschränkenden Beispielen mit zugehörigen Figuren die Erfindung näher erläutert. Darin zeigen
Fig. 1 eine typische Pulsfolge beim Elektropolieren,
Fig. 2 eine erfindungsgemäße Vorrichtung.

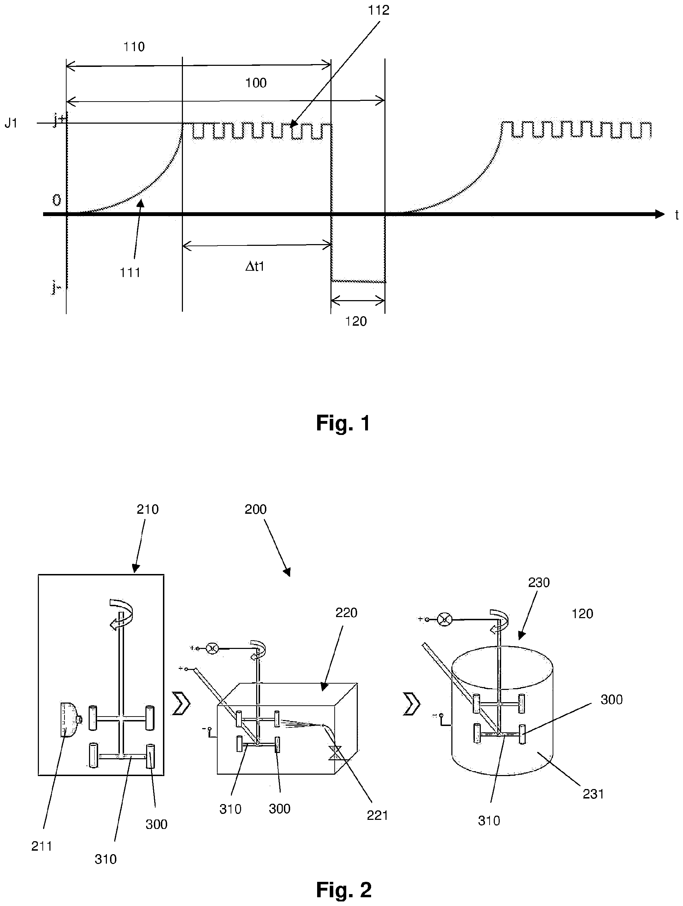

Wie in der Fig. 1 dargestellt, ist besteht eine typische Pulssequenz 100 gemäß der Erfindung aus einem anodischen Puls 110, dessen Stromstärke j+ im zeitlichen Verlauf einen stetigen Anstieg 111 bis zu einem vorgebbaren Wert J1 aufweist. Dieser über eine bestimmte Zeit Δt1 gehaltene anodische Puls 110 wird mit Mikropulsen 112, also Multipulse mit höherer Frequenz, überlagert. An diesen anodischen Puls 110 schließt ein kathodischer Puls 120 in Rechtecksform an.

Diese aus anodischem Puls 110 und kathodischem Puls 120 bestehende Pulssequenz 100 wird solange wiederholt, bis der gewünschte Abtrag und damit verbunden die gewünschte Oberflächengüte erzielt wird. Die Dauer und Höhe des stetigen Anstiegs 111, nämlich der Flanke bzw. Rampe ist von der Ausgangsrauigkeit und der daraus folgenden benötigten Ätzdauer abhängig. Die Anzahl und Höhe der Mikropulse 112 sind materialabhängig.

Nachfolgend werden beispielhaft Anwendungsbeispiele für den Einsatz des erfindungsgemäßen Verfahrens für 3D-gedruckte Teile angeführt.

### Beispiel 1: Glätten eines Bauteils aus einer Aluminiumlegierung

Ein 3D-gedruckter Bauteil aus AlMgSi10 mit Stützstrukturen weist eine Ausgangsrauigkeit Ra = 100 µm auf.

Der Bauteil wird wie folgt behandelt:
1.1. Reinigung des Bauteils, insbesondere Entfetten und Spülen.
1.2. Entfernung der Stützstrukturen durch ein elektrochemisch unterstütztes Nassstrahlen und einem anschließenden Spülen mit Ultraschallunterstützung.
1.3. Entgraten mittels elektrochemisch unterstütztem Ätzen und erneutes Spülen.
1.4. Glättung der Oberfläche des Bauteils mittels dem erfindungsgemäßen Verfahren

Der anodische Puls besteht hierbei aus einer Rampe mit einer Spannung von 0 V bis 5 V ansteigend und einer anschließendem Spannungsplateau mit Mikropulsen von 5 V bis 20 V bei einer Frequenz von 5 Hz.

Der Elektrolyt hierbei besteht aus:
68 Vol.-% Polyphosphorsäure
20 Vol.-% n-Butanol
20 g/l Ammoniumhydrogendifluorid
5 g/l Ethanolamin
Wasser

Die Arbeitstemperatur beträgt 80°C.
1.5. Spülen
1.6. Trocknen

Die Rauigkeit des bearbeiteten Bauteils reduziert sich durch diese Oberflächenbehandlung um einen Faktor 100 auf Ra=1,0 µm

### Beispiel 2: Glätten eines Bauteils aus einer Titanlegierung (Ti6AI4V)

Der 3D-gedruckte Bauteil aus einer Titanlegierung mit einer Ausgangsrauigkeit von Ra = 14 µm wird wie folgt behandelt:
2.1. Reinigung des Bauteils, insbesondere Entfetten und Spülen.
2.2. Entgraten mittels elektrochemisch unterstütztem Ätzen und erneutes Spülen.
2.3. Glättung der Oberfläche des Bauteils mittels erfindungsgemäßen Verfahren

Der anodische Puls besteht hierbei aus einer Rampe mit einer Spannung von 0 V bis 3 V ansteigend und einer anschließendem Spannungsplateau mit Mikropulsen von 3 V bis 12 V bei einer Frequenz von 5 Hz. Die Pulssequenz besteht aus 10 Wiederholungen des anodischen Pulses und einem anschließenden kathodischen Rechteckpuls mit 15 V.

Der Elektrolyt besteht aus:
25 Vol.-% Schwefelsäure
15 Vol.-% Fluorwasserstoffsäure
60 Vol.-% Eisessigsäure

Die Temperatur des Elektrolytbades liegt bei Raumtemperatur.
1.5. Spülen
1.6. Trocknen

Die Rauigkeit des bearbeiteten Bauteils reduziert sich durch diese Oberflächenbehandlung um einen Faktor 17 auf Ra = 0,5 bis 0,8 µm.

### Beispiel 3: Glätten eines Gussteils aus einer Magnesiumlegierung

Ein Gussteil aus einer Magnesiumlegierung (AZ91) mit einer Ausgangsrauigkeit von Ra = 8 µm wird gemäß der Erfindung wie folgt bearbeitet:
3.1. Vorbehandlung wie in den vorhergehenden Beispielen
3.2. Glättung der Oberfläche mittels des erfindungsgemäßen Verfahrens des Puls-Elektropolierens.

Der Puls besteht aus folgendem Signalverlauf: (a) Rampe mit einer Spannung von 0-20V ansteigend, (b) ausgehend von der Endspannung Anlegen von Mikropulsen mit einem Spannungssignal von 12 V bis 20 V mit einer Frequenz von 2 Hz.

Der Elektrolyt hierbei besteht aus:
45 Vol.-% Phosphorsäure
35 Vol.-% Ethanol
Wasser

Die Arbeitstemperatur liegt zwischen 30°C und 50°C.
3.3. Spülen
3.4. Trocknen

Die Rauigkeit wurde im Laufe des ganzen Prozesses um einen Faktor 16 auf Ra = 0,5 µm reduziert.

### Beispiel 4: Glätten eines Bauteils aus einer Magnesiumlegierung

Ein 3D-gedruckter Bauteil aus einer Magnesiumlegierung mit einer Ausgangsrauigkeit von Ra = 50 µm wurde gemäß der Erfindung bearbeitet.
4.1. Vorbehandlung wie bei den vorhergegangenen Beispielen
4.2. Elektrochemisch unterstütztes Nassstrahlen und anschließend ultraschallunterstütztes Spülen
4.3. Entgraten durch elektrochemisch unterstütztes Ätzen und anschließend Spülen
4.4. Glättung der Oberfläche mittels Puls-Elektropolieren.

Der Puls besteht aus folgendem Signalverlauf: (a) Rampe mit einer Spannung von 0-25 V ansteigend, (b) ausgehend von der Endspannung Anlegen von Mikropulsen mit einem Spannungssignal von 12 V bis 25 V mit einer Frequenz von 2 Hz.

Der Elektrolyt hierbei besteht aus:
45 Vol.-% Phosphorsäure
35 Vol.-% Ethanol
Wasser

Die Arbeitstemperatur liegt zwischen 30°C und 50°C.

Die Rauigkeit wird durch das erfindungsgemäße Verfahren um einen Faktor 50 auf Ra = 1 µm reduziert.

In einem weiteren Schritt folgt eine Nachbehandlung der geglätteten Oberfläche, nämlich eine keramische Beschichtung mittels plasmaelektrolytischer Oxidation:
4.5. Spülen
4.6. Plasma elektrolytische Oxidation (PEO)
4.7. Spülen
4.8. Trocknen

### Beispiel 5: Glätten eines Stahlteils

Ein 3D-gedrucktes Werkstück aus Stahl (1.4401) mit einer Ausgangsrauigkeit von Ra = 50µm wird gemäß der Erfindung bearbeitet:
5.1. Vorbehandlung und anschließend Spülen
5.2. Elektrochemisch unterstütztes Nassstrahlen und anschließend ultraschallunterstütztes Spülen
5.3. Entgraten durch elektrochemisch unterstütztes Ätzen und anschließend Spülen
5.4. Glättung der Oberfläche mittels erfindungsgemäßem Puls-Elektropolieren.

Der Puls besteht aus folgendem Signalverlauf: (a) Rampe mit einer Spannung von 0-6 V ansteigend, (b) ausgehend von der Endspannung Anlegen von Mikropulsen mit einem Spannungssignal von 2,5 V bis 6 V mit einer Frequenz von 10 Hz, wobei die Pulssequenz 5 Wiederholungen des anodischen Puls und einer anschließenden stromlosen Pause aufweist. Diese Pulssequenz wird ebenfalls wiederholt.

Der Elektrolyt besteht aus:
70 Vol.-% Phosphorsäure
20Vol.-% Schwefelsäure
8Vol.-% PEG
Wasser

Die Arbeitstemperatur beträgt 45-55°C.
5.5. Spülen
5.6. Trocknen

Die Oberflächenrauigkeit wird um einen Faktor 50 auf Ra = 1µm reduziert.

### Beispiel 6: Glätten eines Stahlteils

Ein 3D-gedruckter Teil aus Stahl (1.4401) mit einer Ausgangsrauigkeit von Ra = 50 µm wird gemäß der Erfindung wie in Beispiel 5 bearbeitet, anschließend erfolgt ein Nachbehandlungsschritt mittels Plasmaelektropolieren.

Die Rauigkeit wird hierbei um einen Faktor 500 auf Ra = 0,1µm reduziert.

In der Fig. 2 ist eine Anlage 200 zur Durchführung des erfindungsgemäßen Verfahrens schematisch dargestellt.

In einer ersten Erfassungsstation 210 werden die zu behandelnden Bauteile 300 mit Hilfe einer Kamera 211 digital erfasst. Hierbei werden insbesondere die Oberfläche und Geometrie des jeweiligen Bauteils 300, das auf einer Halterung 310 angeordnet ist, aufgezeichnet und ausgewertet.

Die Halterung 310 wird anschließend in eine zweite Bearbeitungsstation 220 überführt. Diese Vorbearbeitung oder Vorbehandlung der Bauteile 300 kann umfassen:
- 1.: Vorbehandlung
- 1.1.: Entfettung
- 1.2.: Spülen
- 2.: Entfernung der Stützstrukturen
- 2.1.: elektrochemisch unterstütztes Nassstrahlen
- 2.2.: Ultraschallunterstützes Spülen
- 3.: Entgraten
- 3.1.: elektrochemisch unterstütztes Ätzen
- 3.2.: Spülen
- 4.: Vorglättung (optional)
- 4.1.: elektrochemisch unterstütztes Gleitschleifen
- 4.2.: ultraschallunterstütztes Spülen

Eine Möglichkeit, die Wirkung des mechanischen Schleifens und Entgratens zu verbessern, ist die Durchführung des Schleifprozesses in einem Elektrolyten unter Anlegen eines anodischen Potenzials. Bei diesem Verfahren unterstützen sich die mechanischen und die chemischen Abtragprozesse gegenseitig, sodass einerseits eine kürzere Prozesszeit erforderlich ist und andererseits die Qualität des geschliffenen Werkstücks höher ist. Durch geeignet gewählte Elektrodenanordnungen ist es möglich, auch innenliegende Teile zu glätten und zu entgraten. Falls nur die Außenflächen geglättet werden müssen, ist der Prozess auch gleichzeitig für mehrere Teile in einer Trommel durchführbar.

In der in der Fig. 2 dargestellten Bearbeitungsstation 220 erfolgt die Vorbehandlung der Bauteile 300 durch ein elektrochemisch unterstütztes Nassstrahlen mittels eines Jetsystems 221, wobei die Halterung 310 und damit auch die Bauteile 300 elektrisch kontaktiert sind.

An diese Vorbehandlung schließt nun der eigentliche Schritt des Elektropolierens in der Elektropolierstation 230 an, wobei diese Station als Elektrolytbad 231 ausgeführt ist, in das die Bauteile 300 versenkt sind. Der Elektrolyt kann hierbei die in den Anwendungsbeispielen angeführte Zusammensetzung aufweisen und gegebenenfalls zusätzliche Additive, wie beispielsweise Schleifkörper aufweisen.

Anschließend kann gegebenenfalls eine Nachbehandlung vorgesehen sein, wie beispielsweise ein Plasmapolieren, das bevorzugterweise in der Bearbeitungsstation 220 erfolgt.

Zwischen den einzelnen Schritten von Vorbehandlung, Elektropolieren und Nachbehandlung sind stets auch Reinigungsschritte, insbesondere auch Spülschritte vorgesehen.

Nach diesen Schritten, die unmittelbar hintereinander voll automatisiert in einer geschlossenen Anlage durchgeführt werden, kann eine weitere Oberflächenveredelung durchgeführt werden. Diese kann entweder nass-in-nass erfolgen, was insbesondere für galvanische Verfahren zweckmäßig ist (Plasmaelektrolytisches Oxidieren (PEO), galvanische Beschichtung, chemische Metallisierung), oder aber mittels stromloser Verfahren (Lackieren, Versiegeln).

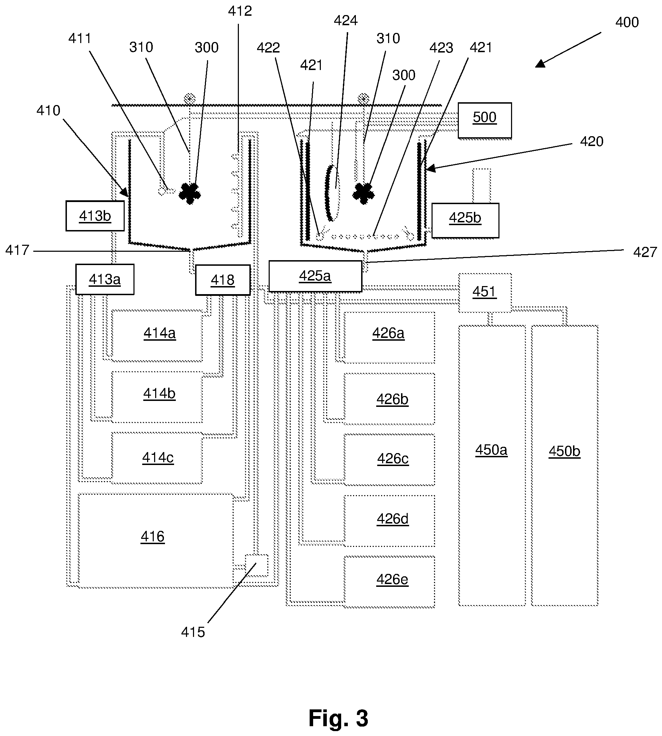

Eine weitere bevorzugte Ausführung der erfindungsgemäßen Anlage kann der Fig. 3 entnommen werden.

In dieser als vollautomatische Bearbeitungsstraße ausgeführten Anlage 400 ist wiederum eine erste Bearbeitungsstation 410, nämlich ein Strahlbecken vorgesehen, in der eine Vorbehandlung eines Werkstücks oder Bauteil 300, das an einer Werkstückaufhängung 310 angeordnet ist, erfolgt. Diese Werkstückaufhängung 310 erlaubt eine Bewegung des Werkstücks 300 in alle drei Raumrichtungen, sowie eine Drehung des Werkstücks 300 um die eigene Hochachse innerhalb der ersten Bearbeitungsstation 410. Ebenso dient die Werkstückaufhängung 310 dem automatisierten Transport des Werkstücks 300 in eine nachfolgende zweite Bearbeitungsstation 420. Zudem wird das Werkstück 300 über die Werkstückaufhängung 310 elektrisch kontaktiert.

In der ersten Bearbeitungsstation 410 ist eine bewegliche Düse 411 angeordnet, die ebenfalls elektrisch mit einem Pulsgenerator 500 verbunden ist. Mit dieser Düse 411, die vor und zurück bewegbar sowie nach oben und unten verschwenkbar ist, wird das Werkstück 300 gezielt gereinigt. Insbesondere erlaubt dieser Aufbau ein elektrochemisches Nassstrahlen zur Beseitigung von Stützstrukturen und/oder Graten, die beim 3D-Druck von insbesondere komplexen Bauteilen praktisch immer auftreten. Zum Spülen des Werkstücks 300 sind innerhalb des Strahlbeckens 410 Spüldüsen 412 vorgesehen.

Die erste Bearbeitungsstation 410 dient nicht nur der Vorbehandlung des Werkstücks 300, sondern kann auch nach dem Elektropolieren für weitere Reinigungsschritte und/oder Nachbehandlungen des Werkstücks 300 eingesetzt werden. Hierfür ist vorgesehen, dass die bewegliche Düse 411 mit unterschiedlichen Medien versorgt werden kann. So ist ein Verteiler- und Pumpsystem 413a vorgesehen, das mit unterschiedlichen Vorratsbehältern 414a, 414b, 414c für beispielsweise einem Nassschleifelektrolyten, für einem PEO-Elektrolyten und für einem Plasmapolierelektrolyten in Verbindung steht.

Zwischen der beweglichen Düse 411 und dem Verteiler- und Pumpsystem 413a ist des Weiteren eine Steuerungs- und Filtereinrichtung 413b angeordnet, die das der der beweglichen Düse 411 zugeführte Medium gegebenenfalls filtriert, um ein Verstopfen der beweglichen Düse 411 zu verhindern, sowie das Medium temperiert, wenn notwendig.

Zur Versorgung der Spüldüsen 412 sind ebenfalls ein Pumpsystem 415 sowie ein Spülwasservorratsbehälter 416 vorgesehen.

Die erste Bearbeitungsstation 410 weist des Weiteren einen Rücklauf 417 auf, der über eine weitere Verteilereinheit 418 eine Rückführung des verwendeten Mediums in den jeweiligen Vorratsbehälter 414a, 414b, 414c, 426 oder aber eine Ableitung in einen Sammelbehälter 450a für saures oder in einen Sammelbehälter 450b für alkalisches Abwasser erlaubt.

In der zweiten Bearbeitungsstation 420, einem Tauchbecken, sind in dem Elektrolytbad Gegenelektroden 421, üblicherweise Stahlelektroden, die mit dem Pulsgenerator 500 elektrisch verbunden sind, angeordnet. Der Elektrolyt wird während des Elektropolierens über ein Umwälzungssystem 422 umgewälzt und seine Temperatur über Temperatursensoren 423 kontrolliert. Des Weiteren ist in dem Tauchbecken 420 ein Ultraschallgeber 424 angeordnet, der bei Bedarf eine Ultraschallunterstützung des jeweiligen Prozesses erlaubt.

Auch die zweite Bearbeitungsstation 420 wird über ein weiteres zweites Verteiler- und Pumpsystem 425a mit unterschiedlichen Elektrolyten aus den Vorratsbehältern 426a, 426b, 426c, 426d, 426e versorgt. Des Weiteren ist eine Filterpumpe 425b, das mit der Umwälzeinrichtung 422 in Verbindung steht, an dem Tauchbecken 420 angeordnet.

Ebenso steht der Rücklauf 427 der zweiten Bearbeitungsstation über das weitere Verteiler- und Pumpsystem 425a mit den Vorratsbehältern 426a, 426b, 426c, 426d, 426e sowie den Sammelbehältern 450a, 450b für Abwasser in Verbindung, wobei ein Verteilerventil 451 die Ableitung des Abwassers entsprechend seinem pH-Wert regelt.

Die zweite Bearbeitungsstation 420 ist insbesondere für das Elektropolieren eingerichtet. Ebenso können in dieser Station auch Entfettung, Entgraten, Plasmapolieren und/oder eine plasmaelektrolytische Oxidation an dem Werkstück 300 durchgeführt werden.

Die Anlage 400 wie in Fig. 3 gezeigt besteht aus zwei Bearbeitungsbecken 410, 420, in denen die unterschiedlichen Bearbeitungsschritte wie in den Beispielen beschrieben durchgeführt werden. Die Anlage 400 wird hierbei vollautomatisch mit einer handelsüblichen speicherprogrammierbaren Steuerung (nicht gezeigt) gesteuert.

Der Pulsgenerator 500 ist in der Lage, beliebige einprogrammierte Stromfolgen auszugeben, insbesondere Gleichstrom, Wechselstrom, Rechteckpulse, Pulse mit frei programmierbaren Flanken und aufgesetzte Mikropulse.

Die Bearbeitungsbecken 410, 420 verfügen über Füllstandsensoren und Temperatursensoren; die Anlage 400 ist zudem mit zusätzlichen Sensoren, beispielsweise Positionssensoren für die Werkstückaufhängung 310, einem Sensor für die Anwesenheit des Werkstücks 300 in der Aufhängung, Motorsensoren und dergleichen ausgestattet, um fehlerhafte Betriebszustände zu erkennen und bei Bedarf den Operator zu alarmieren.

Die Vorratsbehälter 414a, 414b, 414c, 416, 426a, 426b, 426c, 426d, 426e können bei Bedarf thermostatisiert werden, um die Prozesszeiten so kurz wie möglich zu halten.

### Eine typische Prozessfolge ist nachfolgend beschrieben:

Die Werkstücke 300, die aus dem 3D-Drucker kommen, sind prozessbedingt mit einer Grundplatte verbunden und müssen in einem ersten Arbeitsschritt mittels Funken- bzw. Drahterosion von dieser getrennt werden. Dies ist ein üblicher Nachbehandlungsschritt bei der Herstellung von Werkstücken 300 im 3D-Druck. Die losen Teile 300 werden anschließend in eine Eingangsschleuse (nicht dargestellt) der erfindungsgemäßen Anlage 400 eingebracht.

In der Eingangsschleuse werden die Teile 300 unter Zuhilfenahme digitaler Bildverarbeitung automatisch ausgerichtet und auf eine passende Aufnahme aufgespannt.

Danach schließen die einzelnen Schritte des erfindungsgemäßen Verfahrens an.

### 1. Entfettung im Tauchbecken 420

Das Tauchbecken 420 wird aus dem Vorratsbehälter 426a mit einem Entfettungselektrolyten gefüllt und auf Prozesstemperatur gebracht. Anschließend wird das Werkstück 300 in den Elektrolyten getaucht und mit oder ohne elektrolytischer Unterstützung entfettet. Nach der Beendigung des Entfettungsschrittes wird der Entfettungselektrolyt wieder in das Vorratsgefäß 426a zurückgepumpt und das Werkstück 300 wird in das Strahlbecken 410 überführt, um, dort mit VE-Wasser aus den Sprühdüsen 412 abgespült zu werden.

### 2. Elektrochemisch unterstütztes Nassstrahlen im Strahlbecken 410

Die für den 3D-Druck erforderlichen Stützstrukturen werden in diesem Prozessschritt entfernt. Die kombinierte Beweglichkeit von Werkstückaufhängung 310 und Strahldüse 411 erlaubt es, selektiv jeden beliebigen Punkt des Werkstücks 300 gezielt zu bearbeiten. So ist es z.B. möglich, unterschiedliche Typen von Stützstrukturen mit individuell angepassten Pulsströmen zu behandeln.

Anschließend wird das Werkstück 300 erneut in die zweite Bearbeitungsstation 420 überführt.

### 3. Elektrochemisches Entgraten im Tauchbecken 420

Als nächster Schritt werden die im vorigen Schritt nicht entfernbaren Reste der Stützstrukturen sowie grobe Rauigkeiten eliminiert. Das Tauchbecken 420 wird mit dem Entgratelektrolyten aus dem Vorratsbehälter 426b gefüllt, auf Prozesstemperatur gebracht, das Werkstück 300 eingetaucht und der Prozess durchgeführt.

Auch der nächste Bearbeitungsschritt erfolgt in der zweiten Bearbeitungsstation 420.

### 4. Pulselektropolieren im Tauchbecken 420

Das Tauchbecken wird aus dem Vorratsgefäß 426c mit dem Polierelektrolyten gefüllt und auf Prozesstemperatur gebracht. Das zuvor nassgestrahlte Werkstück 300 wird in den Polierelektrolyten getaucht und der Polierprozess durchgeführt. Danach wird der Elektrolyt in das Vorratsgefäß 426c zurückgepumpt und das Werkstück 300 wiederum im Strahlbecken 410 mit VE-Wasser aus den Sprühdüsen 412 gereinigt

### 5. Plasmapolieren

Dieser Schritt kann je nach Anforderung im Tauchbecken 420 oder im Strahlbecken 410 durchgeführt werden. In letzterem Fall ist es möglich, einzelne Stellen des Werkstücks 300 selektiv zu polieren.

### 6. PEO-Beschichtung

Dieser Schritt kann ebenfalls im Tauchbecken 420 auf das ganze Werkstück 300 oder im Strahlbecken 410 auf ausgewählte Stellen des Werkstücks 300 angewendet werden.

Es versteht sich, dass die oben beschriebenen Ausführungsbeispiele nicht einschränkend zu betrachten sind. So können je nach Material der Bauteile unterschiedliche Elektrolyten zum Einsatz kommen. Ebenso können unterschiedliche Bearbeitungsschritte vor und/oder nach dem Pulselektropolieren vorgesehen sein. Hierzu kann die vorzugsweise vollautomatisch arbeitende Anlage neben den beiden beschriebenen Bearbeitungsstationen noch weitere Stationen, wie beispielsweise eine Nassschleifstation und/oder Bearbeitungsbecken vorgesehen sein.

## Patentansprüche

1. Elektropolierverfahren, insbesondere für im 3D-Druck hergestellte Bauteile (300) aus Metall, wobei in einem ersten Schritt eine Reinigung erfolgt, wobei in einem zweiten Schritt zumindest ein zu bearbeitendes Bauteil (300) als erste Elektrode fungiert und zumindest eine zweite Elektrode als Gegenelektrode (422) vorgesehen ist, und zumindest ein teilweiser Abtrag eines Bereichs der Bauteiloberfläche in einem Elektrolytbad durch Anlegen von Strom an dem Bauteil (300) erfolgt, wobei der Strom in Form von sich wiederholenden Pulssequenzen (100) angelegt wird, wobei zumindest ein anodischer Puls (110) vorgesehen ist, dessen Stromstärke (j+) im zeitlichen Verlauf (t) einen stetigen Anstieg (111) bis zu einem vorgebbaren Wert (J1) aufweist, **dadurch gekennzeichnet, dass** anschließend an den Anstieg (111) der anodische Puls (110) Mikropulse (112) aufweist.

2. Verfahren nach Anspruch 1, **dadurch gekennzeichnet, dass** sich an dem zumindest einen anodischen Puls (110) zumindest ein zweiter anodischer Puls anschließt, wobei der zumindest zweite Puls vorzugsweise unterschiedlich von dem ersten Puls (110) ist, und der zumindest erste Puls und der zumindest zweite Puls eine sich wiederholende Pulssequenz (100) bilden, die bevorzugterweise durch eine Pulspause und/oder durch zumindest einen kathodischen Puls (120) unterbrochen wird.

3. Verfahren nach Anspruch 1 oder Anspruch 2, **dadurch gekennzeichnet, dass** die Pulse (110) eine mittlere Stromdichte von 0,5 A/dm2 bis 30 A/dm2 aufweisen.

4. Verfahren nach einem der Ansprüche 1 bis 3, **dadurch gekennzeichnet, dass** die Pulse (110) und/oder die Pulspausen eine Pulslänge von 0,0005 s bis 5 s aufweisen.

5. Verfahren nach einem der Ansprüche 1 bis 4, **dadurch gekennzeichnet, dass** ein Elektrolyt vorgesehen ist, der einen pH-Wert von 1 bis 10 aufweist, wobei der Elektrolyt vorzugsweise aus einer Gruppe ausgewählt ist, die einen Elektrolyten auf Basis von Mineralsäure oder organischen Säuren oder Gemische daraus enthält oder wobei der Elektrolyt vorzugsweise aus der Gruppe ausgewählt ist, die einen Elektrolyten auf Basis von Hydroxiden, Ammoniak oder organischen Aminen oder Gemische daraus enthält.

6. Verfahren nach Anspruch 5, **dadurch gekennzeichnet, dass** der Elektrolyt periodisch oder kontinuierlich bewegt wird.

7. Verfahren nach einem der Ansprüche 1 bis 6, **dadurch gekennzeichnet, dass** zusätzlich eine Ultraschallunterstützung vorgesehen ist.

8. Verfahren nach einem der Ansprüche 1 bis 7, **dadurch gekennzeichnet, dass** das Bauteil (300) aus Metall, bevorzugt aus Stahl, Nickelbasislegierungen, Aluminiumlegierungen, Magnesiumlegierungen oder Titanlegierungen besteht.

9. Verfahren nach Anspruch 8, **dadurch gekennzeichnet, dass** im in ersten Schritt eine Entfernung von Verschmutzungen und zusätzlich ein mechanisches Vorpolieren und/oder ein Beizen des Bauteils (300) erfolgt, im zweiten Schritt das elektrochemische Oberflächenverfahren erfolgt und in einem dritten Schritt eine Nachbehandlung des Bauteils (300) erfolgt.

10. Verfahren nach Anspruch 8 oder Anspruch 9, **dadurch gekennzeichnet, dass** vor dem Reinigen eine insbesondere digitale Erfassung der Oberfläche des Bauteils (300) erfolgt.

11. Verfahren nach einem der Ansprüche 8 bis 10, **dadurch gekennzeichnet, dass** die Nachbehandlung ein Beschichtungsverfahren umfasst.

12. Verfahren nach Anspruch 11, **dadurch gekennzeichnet, dass** ein galvanischer Beschichtungsschritt erfolgt oder dass der Beschichtungsschritt eine plasmaelektrolytische Oxidation umfasst oder dass ein plasmaelektrolytischer Polierschritt vorgesehen ist.

13. Anlage (200, 400) für ein elektrochemisches Elektropolierverfahren zur Bearbeitung von metallischen Bauteilen (300) nach einem der Ansprüche 1 bis 12, mit zumindest einer ersten Bearbeitungsstation (220, 410) zur Reinigung von bevorzugterweise im 3D-Druck hergestellter Bauteilen (300), wobei zumindest eine zweite Bearbeitungsstation (230, 420) vorgesehen ist, **gekennzeichnet durch** eine speicherprogrammierbare Steuerung und einen Pulsgenerator (500), wobei der Pulsgenerator (500) in der Lage ist, beliebige einprogrammierte Stromfolgen gemäß dem Verfahren nach Anspruch umfassend Gleichstrom, Wechselstrom, Rechteckpulse, Pulse mit frei programmierbaren Flanken und aufgesetzte Mikropulse auszugeben.

14. Anlage (200, 400) nach Anspruch 13, **dadurch gekennzeichnet, dass** zusätzliche eine Erfassungsstation (210) zur Erfassung der Geometrie und Oberflächenbeschaffenheit der zu bearbeitenden Bauteile (300) vorgesehen ist.

15. Anlage (200, 400) nach Anspruch 13, **dadurch gekennzeichnet, dass** die erste Bearbeitungsstation (220, 410) und die zweite Bearbeitungsstation (230, 420) zusätzlich zur Nachbehandlung der Bauteile (300), insbesondere zu deren Beschichtung eingerichtet sind.

## Claims

1. An electropolishing method, in particular for metal components (300) produced in 3D printing, wherein a cleaning occurs in a first step, wherein at least one component (300) to be machined functions as a first electrode and at least one second electrode is provided as a counter electrode (422) in a second step, and at least a partial removal of a portion of the component surface occurs in an electrolyte bath by applying current to the component (300), wherein the current is applied in the form of repeating pulse sequences (100), wherein at least one anodic pulse (110) is provided, the current intensity (j+) of which displays a steady increase (111) over the course of time (t) up to a specifiable value (J1), **characterized in that** the anodic pulse (110) displays micropulses (112) subsequent to the increase (111).

2. A method according to claim 1, **characterized in that** at least one second anodic pulse adjoins the at least one anodic pulse (110), wherein the at least second pulse is preferably different from the first pulse (110), and the at least first pulse and the at least second pulse form a repeating pulse sequence (100), which is preferably interrupted by a pulse pause and/or by at least one cathodic pulse (120).

3. A method according to claim 1 or claim 2, **characterized in that** the pulses (110) have an average current density of 0.5 A/dm² to 30 A/dm².

4. A method according to any of claims 1 to 3, **characterized in that** the pulses (110) and/or the pulse pauses have a pulse length of 0.0005 s to 5 s.

5. A method according to any of claims 1 to 4, **characterized in that** an electrolyte is provided which has a pH ranging from 1 to 10, wherein the electrolyte is preferably selected from a group comprising an electrolyte based on mineral acids or organic acids or mixtures thereof or wherein the electrolyte is preferably selected from the group comprising an electrolyte based on hydroxides, ammonia or organic amines or mixtures thereof.

6. A method according to claim 5, **characterized in that** the electrolyte is moved periodically or continuously.

7. A method according to any of claims 1 to 6, **characterized in that** ultrasound support is additionally provided.

8. A method according to any of claims 1 to 7, **characterized in that** the component (300) is made of metal, preferably made of steel, nickel-based alloys, aluminium alloys, magnesium alloys or titanium alloys.

9. A method according to claim 8, **characterized in that** a removal of contaminants and, additionally, a mechanical pre-polishing and/or staining of the component (300) occur in a first step, the electrochemical surface process occurs in a second step, and a post-treatment of the component (300) occurs in a third step.

10. A method according to claim 8 or claim 9, **characterized in that**, prior to the cleaning, the surface of the component (300) is recorded in particular digitally.

11. A method according to any of claims 8 to 10, **characterized in that** the post-treatment comprises a coating process.

12. A method according to claim 11, **characterized in that** a step of electroplating is performed and the coating step comprises a plasma electrolytic oxidation and a step of plasma electrolytic polishing is provided.

13. A plant (200, 400) for an electrochemical electropolishing method for machining metallic components (300) according to any of claims 1 to 12, comprising at least one first machining station (220, 410) for the cleaning of components (300) which preferably have been produced in 3D printing, with at least one second machining station (230, 420) being provided, **characterized by** a programmable logic controller and a pulse generator (500), with the pulse generator (500) being capable of outputting any programmed current sequences according to the method according to claim 1 comprising direct current, alternating current, rectangular pulses, pulses with freely programmable flanks and micropulses that have been applied.

14. A plant (200, 400) according to claim 13, **characterized in that** a detection station (210) for detecting the geometry and surface finish of the components (300) to be machined is additionally provided.

15. A plant (200, 400) according to claim 13, **characterized in that** the first machining station (220, 410) and the second machining station (230, 420) are additionally arranged for the post-treatment of the components (300), in particular for their coating.

## Revendications

1. Procédé d'électropolissage, en particulier pour des pièces (300) métalliques fabriquées par impression 3D, dans lequel, dans une première étape, un nettoyage a lieu, et dans lequel, dans une deuxième étape, au moins une pièce (300) à traiter fonctionne comme une première électrode et au moins une deuxième électrode est prévue comme contre-électrode (422), et au moins un retrait partiel d'une zone de la surface de la pièce dans un bain d'électrolyte est effectué par application d'un courant à la pièce (300), le courant étant appliqué sous la forme de séquences d'impulsions répétitives (100), au moins une impulsion anodique (110) dont l'intensité (j+) au fil du temps (t) présente une augmentation constante (111) jusqu'à une valeur prédéfinissable (J1) étant prévue, **caractérisé en ce qu'**à la suite de l'augmentation (111), l'impulsion anodique (110) présente des micro-impulsions (112).

2. Procédé selon la revendication 1, **caractérisé en ce qu'**à l'au moins une impulsion anodique (110) succède au moins une deuxième impulsion anodique, l'au moins deuxième impulsion étant de préférence différente de la première impulsion (110), et l'au moins première impulsion et l'au moins deuxième impulsion formant une séquence d'impulsions répétitive (100) qui est de préférence interrompue par une pause d'impulsions et/ou par au moins impulsion cathodique (120).

3. Procédé selon la revendication 1 ou 2, **caractérisé en ce que** les impulsions (110) présentent une densité de courant moyenne de 0,5 A/dm² à 30 A/dm².

4. Procédé selon une des revendications 1 à 3, **caractérisé en ce que** les impulsions (110) et/ou les pauses d'impulsions présentent une longueur d'impulsion de 0,0005 s à 5 s.

5. Procédé selon une des revendications 1 à 4, **caractérisé en ce qu'**il est prévu un électrolyte qui présente une valeur pH de 1 à 10, l'électrolyte étant de préférence choisi parmi un groupe qui contient un électrolyte à base d'acide minéral ou d'acides organiques ou de mélanges de ceux-ci ou l'électrolyte étant de préférence choisi parmi un groupe qui contient un électrolyte à base d'hydroxydes, d'ammoniac ou d'amines organiques ou de mélanges de ceux-ci.

6. Procédé selon la revendication 5, **caractérisé en ce que** l'électrolyte est déplacé périodiquement ou en continu.

7. Procédé selon une des revendications 1 à 6, **caractérisé en ce qu'**il est en outre prévu une assistance ultrasonique.

8. Procédé selon une des revendications 1 à 7, **caractérisé en ce que** la pièce (300) métallique est de préférence en acier, en alliages à base de nickel, en alliages d'aluminium, en alliages de magnésium ou en alliages de titane.

9. Procédé selon la revendication 8, **caractérisé en ce que** dans la première étape ont lieu une élimination des impuretés ainsi qu'un pré-polissage mécanique et/ou un décapage de la pièce (300), dans la deuxième étape a lieu le traitement de surface électrochimique et dans une troisième étape a lieu un post-traitement de la pièce (300).

10. Procédé selon la revendication 8 ou la revendication 9, **caractérisé en ce qu'**avant le nettoyage a lieu une détection notamment numérique de la surface de la pièce (300).

11. Procédé selon une des revendications 8 à 10, **caractérisé en ce que** le post-traitement comprend une opération de revêtement.

12. Procédé selon la revendication 11, **caractérisé en ce qu'**une étape de revêtement galvanique a lieu ou que l'étape de revêtement comprend une oxydation par plasma électrolytique ou qu'il est prévu une étape de polissage par plasma électrolytique.

13. Installation (200, 400) pour un procédé d'électropolissage électrochimique pour traiter des pièces métalliques (300) selon une des revendications 1 à 12, avec au moins une première station de traitement (220, 410) pour le nettoyage de pièces (300) fabriquées de préférence par impression 3D, dans laquelle il est prévu au moins une deuxième station de traitement (230, 420) **caractérisée par** une commande programmable par mémoire et un générateur d'impulsions (500), le générateur d'impulsions (500) étant capable d'émettre des séquences électriques programmées quelconques selon le procédé selon la revendication 1, comprenant du courant continu, du courant alternatif, des impulsions rectangulaires, des impulsions avec des flancs librement programmables et des micro-impulsions superposées.

14. Installation (200, 400) selon la revendication 13, **caractérisée en ce qu'**il est en outre prévu une station de détection (210) pour détecter la géométrie et l'état de surface des pièces (300) à traiter.

15. Installation (200, 400) selon la revendication 13, **caractérisée en ce que** la première station de traitement (220, 410) et la deuxième station de traitement (230, 420) sont équipées pour réaliser, outre le post-traitement des pièces (300), notamment leur revêtement.
